# EUROPEAN PATENT APPLICATION

(11) **EP 2 680 322 A1**
(43) Date of publication of application: **01.01.2014**
(21) Application number: 13171522.9
(22) Date of filing: 11.06.2013
(51) Int. Cl.: H01L 33/00

(54) **Method of manufacturing an led**

(30) Priority: 28.06.2012 JP 2012145448
(71) Applicant: NITTO DENKO CORPORATION, Ibaraki-shi, Osaka 567-8680 (JP)
(72) Inventor: Takahashi, Tomokazu, Ibaraki-shi, Osaka 567-8680 (JP); Akizuki, Shinya, Ibaraki-shi, Osaka 567-8680 (JP); Sugimura, Toshimasa, Ibaraki-shi, Osaka 567-8680 (JP); Matsumura, Takeshi, Ibaraki-shi, Osaka 567-8680 (JP); Uenda, Daisuke, Ibaraki-shi, Osaka 567-8680 (JP)
(74) Representative: Gill, Stephen Charles

(57) **Abstract**

A method of manufacturing an LED according to an embodiment of the present invention includes:
back-grinding a substrate of an LED wafer including a light emitting element and the substrate; and
attaching a protective sheet to the LED wafer one of prior to the back-grinding and after grinding the substrate in the back-grinding.

## Description

### BACKGROUND OF THE INVENTION

### 1. Field of the Invention

The present invention relates to a method of manufacturing an LED.

### 2. Description of the Related Art

Hitherto, in manufacture of an LED, a light emitting element is laminated on a substrate to form an LED wafer, and then a surface of the substrate on a side opposite to the light emitting element is ground (back-ground) to thin the substrate (for example, Japanese Patent Application Laid-open Nos. 2005-150675 and 2002-319708). Generally, this grinding is carried out while fixing a surface of the substrate on the light emitting element side to a table via a pressure-sensitive adhesive wax. The LED wafer that has undergone grinding is subjected to, for example, steps of heating the wax to release the LED wafer, cleaning the wax adhering on the LED wafer, cutting (dicing) the LED wafer to singulate small element pieces, and forming a reflective layer on the surface of the substrate on the side opposite to the light emitting element. The LED wafer that has undergone the back-grinding step is very thin, and hence there is a problem in that, in those steps of the post-process, damage such as cracking easily occurs.

### SUMMARY OF THE INVENTION

The present invention has been made to address the above-mentioned conventional problem, and has an object to provide a method of manufacturing an LED, which is capable of manufacturing an LED with high yields by preventing damage to the LED wafer.

A method of manufacturing an LED according to an embodiment of the present invention includes:
back-grinding a substrate of an LED wafer including a light emitting element and the substrate; and
attaching a protective sheet to the LED wafer one of prior to the back-grinding and after grinding the substrate in the back-grinding.

In an embodiment of the present invention, the attaching a protective sheet includes, prior to the back-grinding, attaching the protective sheet on an outer side of the light emitting element of the LED wafer.

In an embodiment of the present invention, the grinding the substrate in the back-grinding is carried out by attaching the protective sheet to a table via a pressure-sensitive adhesive wax to fix the LED wafer to the table, and the method further comprises, after the grinding the substrate, taking off the protective sheet to remove, from the LED wafer, the pressure-sensitive adhesive wax adhering on the LED wafer with the protective sheet, which has been released from the table.

In an embodiment of the present invention, the attaching a protective sheet includes, after the grinding the substrate in the back-grinding, attaching the protective sheet on an outer side of the substrate of the LED wafer.

In an embodiment of the present invention, the method further includes, after the back-grinding, forming a reflective layer.

According to the present invention, the protective sheet is attached to the LED wafer, and thus the damage to the LED wafer may be prevented to manufacture the LED with high yields.

### BRIEF DESCRIPTION OF THE DRAWINGS

In the accompanying drawings:
FIGS. **1A** to **1D** are schematic views illustrating respective steps of a method of manufacturing an LED according to an embodiment of the present invention;
FIG. **2** is a schematic sectional view of an LED wafer used in the method of manufacturing an LED according to the embodiment of the present invention;
FIGS. **3A** to **3D** are schematic views illustrating respective steps of a method of manufacturing an LED according to another embodiment of the present invention;
FIGS. **4A** to **4F** are schematic views illustrating respective steps after a back-grinding step in a method of manufacturing an LED according to still another embodiment of the present invention;
FIGS. **5A** to **5F** are schematic views illustrating respective steps after a back-grinding step in a method of manufacturing an LED according to further another embodiment of the present invention; and
FIGS. **6A** to **6F** are schematic views illustrating respective steps after a back-grinding step in a method of manufacturing an LED according to yet another embodiment of the present invention.

### DETAILED DESCRIPTION OF THE PREFERRED EMBODIMENTS

A method of manufacturing an LED according to the present invention includes attaching a protective sheet to an LED wafer including a light emitting element and a substrate. In the present invention, the protective sheet may be attached to the LED wafer prior to a back-grinding step (first embodiment), or the protective sheet may be attached to the LED wafer after the substrate is ground in the back-grinding step (second embodiment). In the present invention, the LED wafer is protected by the protective sheet, and thus during the back-grinding step, steps after the back-grinding step, and handling between the steps, the damage (for example, cracking) to the LED wafer can be prevented.

### A. First Embodiment

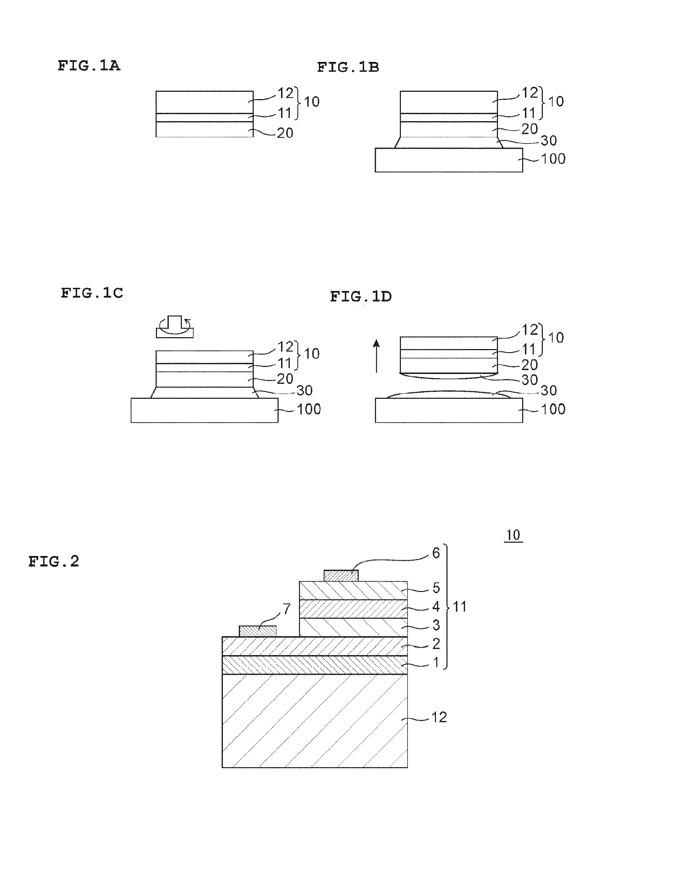

FIGS. **1A** to **1D** are schematic views illustrating respective steps of a method of manufacturing an LED according to an embodiment of the present invention. Further, FIG. **2** is a schematic sectional view of an LED wafer **10.** The LED wafer **10** includes a light emitting element **11** and a substrate **12.** The light emitting element **11** includes a buffer layer **1,** an n-type semiconductor layer **2,** a light emitting layer **3,** a p-type semiconductor layer **4,** a transparent electrode **5,** and electrodes **6** and **7.** The light emitting layer **3** includes, for example, gallium nitride-based compounds (e.g., GaN, AlGaN, and InGaN), gallium phosphide-based compounds (e.g., GaP and GaAsP), gallium arsenide-based compounds (e.g., GaAs, AlGaAs, and AlGaInP), and zinc oxide (ZnO) -based compounds. Note that, although not illustrated, the light emitting element **11** may include any other appropriate members. The substrate **12** is made of any appropriate material. Examples of the material for constituting the substrate **12** include sapphire, SiC, GaAs, GaN, and GaP. The effects of the present invention are markedly obtained when the employed LED wafer **10** is made of such a hard and brittle material as those materials.

In this embodiment, first, as illustrated in FIG. **1A**, prior to the back-grinding step, a protective sheet **20** is attached onto an outer side of the light emitting element **11** of the LED wafer **10.** After that, the LED wafer with the protective sheet is subjected to the back-grinding step (FIGS. **1B** to **1D**).

As the protective sheet **20,** any appropriate sheet may be used. A representative protective sheet includes a base member and a pressure-sensitive adhesive layer. As a material for constituting the base member, there may be given, for example: polyolefins such as polyethylene, polypropylene, polybutene, polybutadiene, and polymethylpentene; and polyvinyl chloride, a polyvinyl chloride copolymer, polyethylene terephthalate, polybutylene terephthalate, polyurethane, an ethylene-vinyl acetate copolymer, an ethylene-(meth)acrylic acid copolymer, an ethylene-(meth)acrylate ester copolymer, polystyrene, polycarbonate, polyimide, and a fluorine-based resin. As a form of the base member, there may be given, for example, film, woven fabric, and non-woven fabric. In addition, the base member may be paper or a metal foil. As a material for constituting the pressure-sensitive adhesive layer, there may be given, for example, a rubber-based resin, an acrylic resin, a silicone-based resin, and a polyimide-based resin.

In the back-grinding step, the LED wafer with the protective sheet is fixed on a table **100.** The LED wafer with the protective sheet is fixed, for example, as illustrated in FIG. **1B**, by attaching the protective sheet **20** to the table **100** via a pressure-sensitive adhesive wax **30.** As the pressure-sensitive adhesive wax **30,** any appropriate wax may be used as long as the LED wafer **10** may be satisfactorily fixed. Examples of the pressure-sensitive adhesive wax **30** include paraffin-based wax. In the embodiment illustrated in FIGS. **1A** to **1D**, the LED wafer **10** and the pressure-sensitive adhesive wax **30** are not brought into contact with each other, and hence the LED wafer **10** can be prevented from being stained.

After the LED wafer **10** is fixed as described above, as illustrated in FIG. **1C****,** a surface of the LED wafer **10** on a side opposite to the light emitting element **11** (that is, the substrate **12)** is ground. With this grinding, the substrate **12** can be thinned to a desired thickness. The thickness of the substrate **12** that has undergone grinding is preferably 10 µm to 500 µm, more preferably 50 µm to 300 µm, most preferably 80 µm to 150 µm. Further, the diameter of the employed LED wafer **10** is preferably 2 inches or more, more preferably 3 inches or more, most preferably 4 inches or more. The upper limit of the diameter of the LED wafer **10** is not particularly limited, but in practical use, the diameter is about 12 inches, for example. In the embodiment illustrated in FIGS. **1A** to **1D**, the LED wafer **10** is protected by the protective sheet **20,** and hence the LED wafer **10** may be prevented from being damaged during grinding. Further, the LED wafer **10** can be prevented from being damaged as described above, and hence a large-size (for example, 4 inches or more) LED wafer larger than the conventional one can be handled, and hence the LED can be manufactured with high yields.

After the substrate **12** is ground as described above, as illustrated in FIG. **1D**, the LED wafer with the protective sheet is released from the table **100.** For example, heating is performed until the pressure-sensitive adhesive wax **30** exhibits flowability, and thus the LED wafer with the protective sheet is released from the table **100.** In the embodiment illustrated in FIGS. **1A** to **1D**, the LED wafer **10** is protected by the protective sheet **20,** and hence the LED wafer **10** may be prevented from being damaged when the LED wafer **10** is released from the table **100.**

In the embodiment illustrated in FIGS. **1A** to **1D**, it is unnecessary to perform a step of cleaning the pressure-sensitive adhesive wax **30,** which has been conventionally necessary after the back-grinding step. This is because, by peeling off the protective sheet **20** from the LED wafer **10,** the pressure-sensitive adhesive wax **30** can also be removed together with the protective sheet **20.** The step of cleaning the pressure-sensitive adhesive wax **30** can be omitted, and hence the use of cleaning liquid such as a solvent can be avoided. Thus, an LED can be simply manufactured with a small environmental load. Further, an adverse effect to the LED due to the cleaning liquid can be prevented.

### B. Second Embodiment

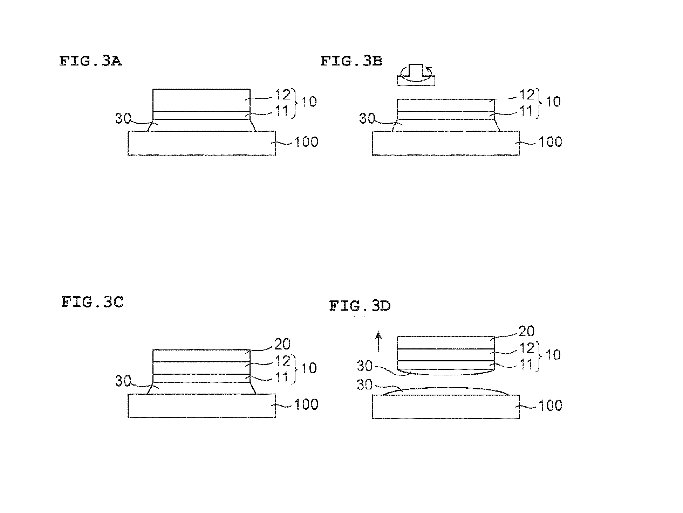

FIGS. **3A** to **3D** are schematic views illustrating respective steps of a method of manufacturing an LED according to another embodiment of the present invention. In this embodiment, after the substrate is ground in the back-grinding step, the protective sheet is attached to the LED wafer. In this embodiment, as illustrated in FIG. **3A****,** the light emitting element **11** of the LED wafer **10** is attached to the table **100** via the pressure-sensitive adhesive wax **30,** to thereby fix the LED wafer **10** onto the table **100.** Subsequently, as illustrated in FIG. **3B**, the surface of the LED wafer **10** on the side opposite to the light emitting element **11** (that is, the substrate **12)** is ground, to thereby thin the substrate **12.** Subsequently, as illustrated in FIG. **3C****,** the protective sheet **20** is attached to the surface of the LED wafer **10** on the side opposite to the light emitting element **11** (that is, on the outer side of the substrate **12).** Subsequently, as illustrated in FIG. **3D**, the LED wafer with the protective sheet is released from the table **100.** Note that, although not illustrated, in this embodiment, after the LED wafer with the protective sheet is released from the table **100,** the pressure-sensitive adhesive wax **30** is cleaned. The pressure-sensitive adhesive wax **30** can be cleaned by immersing the LED wafer with the protective sheet into anorganic solvent which can dissolve the pressure-sensitive adhesive wax.

In the embodiment illustrated FIGS. **3A** to **3D**, the LED wafer **10** is protected by the protective sheet **20,** and hence the LED wafer **10** may be prevented from being damaged when the LED wafer **10** is released from the table **100** and handled thereafter.

### C. Other Steps (Steps after Back-grinding Step)

The LED wafer **10** that has undergone the back-grinding step, in which the substrate **12** has been ground as described above, is subjected to steps of the post-process including, for example, a step of cutting the LED wafer **10** to singulate small element pieces (dicing step), and a step of forming a reflective layer on the surface of the substrate on the side opposite to the light emitting element (reflective layer forming step). According to the manufacturing method of the present invention, the LED wafer **10** is protected by the protective sheet **20** to prevent damage during the respective steps and handling between the respective steps. Therefore, a large-size (for example, 4 inches or more) LED wafer larger than the conventional one can be handled, and hence the LED can be manufactured with high yields.

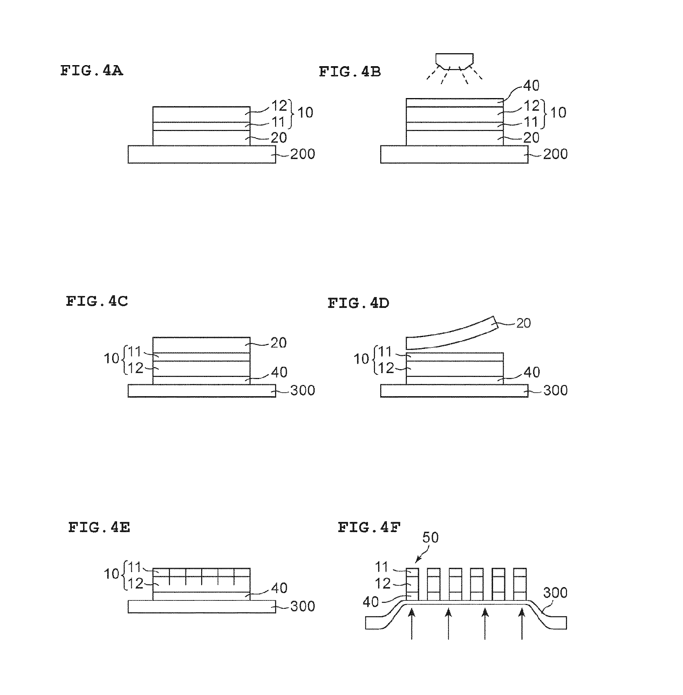

FIGS. **4A** to **4F** are schematic views illustrating respective steps in a method of manufacturing an LED according to still another embodiment of the present invention. FIGS. **4A** to **4F** illustrate steps subsequent to the back-grinding step for the LED wafer with the protective sheet, which is obtained through the above-mentioned first embodiment (embodiment illustrated in FIGS. **1A** to **1D**).

In this embodiment, as illustrated in FIGS. **4A** and **4B**, the LED wafer with the protective sheet, which has been subjected to the back-grinding step, is subjected to the reflective layer forming step. Specifically, the LED wafer with the protective sheet is placed on a table **200** with the protective sheet **20** side down (FIG. **4A**). After that, a reflective layer **40** is formed on the LED wafer on a side opposite to the protective sheet (that is, the substrate **12** side) (FIG. **4B**). By forming the reflective layer **40,** the amount of light to be extracted from the light emitting element **11** can be increased. As a material for constituting the reflective layer **40,** any appropriate material may be used as long as the light from the light emitting element **11** may be satisfactorily reflected. Examples of the material for constituting the reflective layer **40** include metals such as aluminum, silver, gold, palladium, platinum, rhodium, and ruthenium. The reflective layer **40** made of a metal may be formed by, for example, a vapor deposition method (for example, a metal organic chemical vapor deposition method (MOCVD method)). It is preferred that an underlayer formed of, for example, SiO₂, TiO₂, ZrO₂, and/or MgF₂ be formed on the surface of the LED wafer **10** on the side opposite to the light emitting element **11,** and then the reflective layer **40** made of a metal be formed by a vapor deposition method. For example, the LED wafer with the protective sheet (LED wafer with the protective sheet formed in the first embodiment) including the protective sheet **20** on the outer side of the light emitting element **11** of the LED wafer **10** is subjected to the reflective layer forming step, and thus the metal may be prevented from being deposited on the light emitting element **11.**

After the reflective layer **40** is formed, as illustrated in FIGS. **4C** to **4F**, the LED wafer with the protective sheet, which has the reflective layer **40** formed thereon, is subjected to the dicing step. Specifically, the LED wafer with the protective sheet, which has the reflective layer **40** formed thereon, is retained on dicing tape **300** with the protective sheet **20** side up (FIG. **4C**). After that, the protective sheet **20** is peeled off (FIG. **4D**). Subsequently, the LED wafer **10** (substantially, the substrate **12)** is half-cut in the thickness direction from the exposed light emitting element **11** side (FIG. **4E****)**. After that, the dicing tape **300** is expanded so that the LED wafer **10** having the reflective layer **40** formed thereon is split from the cut portion as an origin to obtain LEDs **50** singulated into small element pieces (FIG. **4F****).**

Referring to FIGS. **4E** and **4F****,** description has been made of the embodiment in which the LED wafer **10** is half-cut so as to split the LED wafer from the cut portion as the origin (scribe dicing). In FIG. **4E****,** the LED wafer **10** is half-cut from the light emitting element **11** side. However, the dicing tape **300** may be alternatively attached with the substrate **12** (reflective layer **40)** side up, and the LED wafer **10** may be half-cut from the substrate **12** side (reflective layer **40** side). Further, as a method of cutting the LED wafer, in addition to the above-mentioned scribe dicing, any appropriate method may be adopted. Examples of other methods include a method of cutting the LED wafer **10** in the entire thickness direction to singulate the small element pieces through expanding, and a method of laser cutting only the center portion of the LED wafer **10** in the thickness direction to split the LED wafer **10** from the cut portion as an origin (stealth dicing).

Referring to FIGS. **4A** to **4F****,** description has been made of the embodiment in which the protective sheet **20** is not peeled off after the back-grinding step, and the LED wafer with the protective sheet is subjected to the post-process (in FIGS. **4A** to **4F****,** the reflective layer forming step), but the LED wafer may be subjected to the post-process after the protective sheet **20** is peeled off. It is preferred that, as illustrated in FIGS. **4A** to **4F**, the LED wafer with the protective sheet be subjected to the post-process. This is because, also in the post-process, the thinned LED wafer can be protected, and the damage to the LED wafer can be prevented.

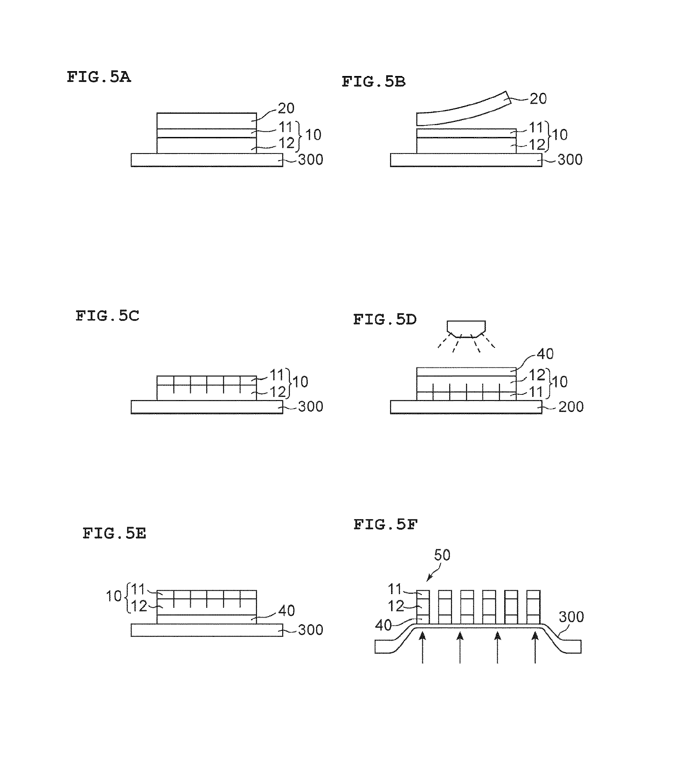

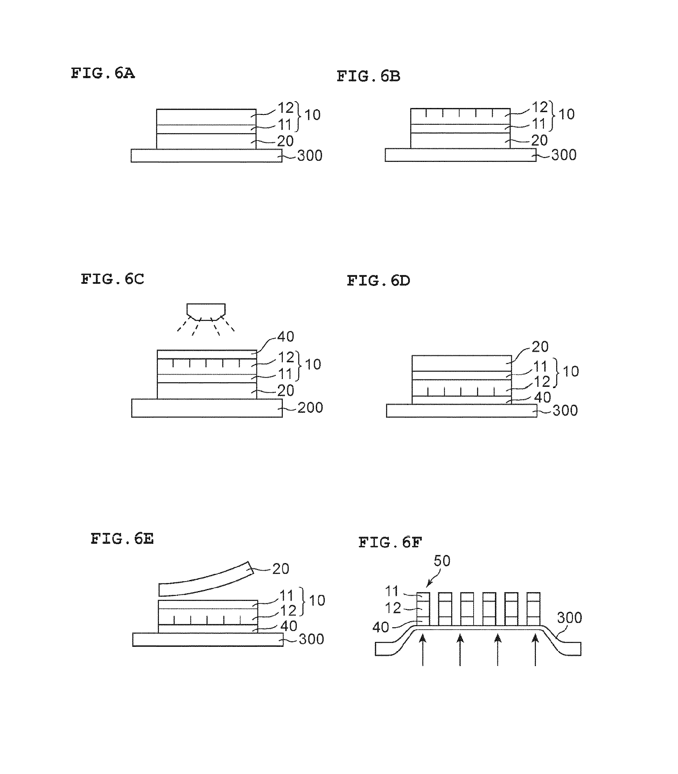

Referring to FIGS. **4A** to **4F**, description has been made of the embodiment in which, prior to the formation of the cut portion for splitting, the reflective layer forming step is performed. The reflective layer forming step may be performed prior to the formation of the cut portion as described above, or may be performed after the cut portion is formed as illustrated in FIGS. **5A** to **5F** and **6A** to **6F.** In an embodiment of the present invention illustrated in FIGS. **5A** to **5F**, the LED wafer with the protective sheet, which has been subjected to the back-grinding step, is retained on the dicing tape **300** with the protective sheet **20** side up (FIG. **5A**), and after that, the protective sheet **20** is peeled off (FIG. **5B**). Subsequently, the LED wafer **10** is half-cut from the exposed light emitting element **11** side (FIG. **5C****)**. Subsequently, the LED wafer **10** having the cut portion formed therein as described above is subjected to the reflective layer forming step. That is, the LED wafer **10** is placed on the table **200** with the light emitting element **11** side down, and the reflective layer **40** is formed on the substrate **12** side of the LED wafer **10** (FIG. **5D**). Subsequently, the LED wafer **10** having the reflective layer **40** formed thereon is retained on the dicing tape **300** again with the side on which the cut portion is formed (light emitting element **11** side) up (FIG. **5E**). Then, the dicing tape **300** is expanded. Thus, the LED wafer **10** is split from the cut portion as an origin, to thereby obtain the LEDs **50** singulated into small element pieces (FIG. **5F****).**

In an embodiment of the present invention illustrated in FIGS. **6A** to **6F****,** the LED wafer with the protective sheet, which has been subjected to the back-grinding step, is retained on the dicing tape **300** with the protective sheet **20** side down (FIG. **6A**). Subsequently, the LED wafer **10** is half-cut from the substrate **12** side (FIG. **6B**). Subsequently, the LED wafer **10** having the cut portion formed therein as described above is subjected to the reflective layer forming step. That is, the LED wafer **10** is placed on the table **200** with the light emitting element **11** side (protective sheet **20** side) down, and the reflective layer **40** is formed on the substrate **12** side of the LED wafer **10** (FIG. **6C**). The LED wafer **10** may be placed on the table **200** under a state in which the dicing tape **300** is still adhering on the outer side of the protective sheet **20,** or may be placed on the table **200** after the dicing tape **300** is peeled off (in the illustrated example, the LED wafer **10** is placed after the dicing tape **300** is peeled off). Subsequently, the LED wafer **10** having the reflective layer **40** formed thereon is retained on the dicing tape **300** again with the protective sheet **20** side up (FIG. **6D**), and then the protective sheet **20** is peeled off (FIG. **6E**). Then, the dicing tape **300** is expanded. Thus, the LED wafer **10** is split from the cut portion as an origin, to thereby obtain the LEDs **50** singulated into small element pieces (FIG. **6F****).**

Regarding the LED wafer with the protective sheet, which is obtained through the above-mentioned second embodiment (embodiment illustrated in FIGS. **3A** to **3D**), in the dicing step, the dicing tape may be attached with the protective sheet side up, and after that, the protective sheet may be peeled off so as to form the cut portion and split the LED wafer. Further, the LED wafer with the protective sheet, which is obtained through the above-mentioned second embodiment, may be subjected to the dicing step after the protective sheet is peeled off. At this time, the dicing tape may be attached to any one of the light emitting element side and the substrate side of the LED wafer.

The LED wafer with the protective sheet, which is obtained through the above-mentioned second embodiment, may be subjected to the reflective layer forming step after the protective sheet is peeled off. The reflective layer forming step may be performed any one of prior to and after the formation of the cut portion, similarly to that performed for the LED wafer obtained through the first embodiment.

## Claims

1. A method of manufacturing an LED, the method comprising:
back-grinding a substrate of an LED wafer including a light emitting element and the substrate; and
attaching a protective sheet to the LED wafer one of prior to the back-grinding and after grinding the substrate in the back-grinding.

2. A method of manufacturing an LED according to claim 1, wherein the attaching a protective sheet comprises, prior to the back-grinding, attaching the protective sheet on an outer side of the light emitting element of the LED wafer.

3. A method of manufacturing an LED according to claim 2, wherein the grinding the substrate in the back-grinding is carried out by attaching the protective sheet to a table via a pressure-sensitive adhesive wax to fix the LED wafer to the table, and
wherein the method further comprises, after the grinding the substrate, taking off the protective sheet to remove, from the LED wafer, the pressure-sensitive adhesive wax adhering on the LED wafer with the protective sheet, which has been released from the table.

4. A method of manufacturing an LED according to claim 1, wherein the attaching a protective sheet comprises, after the grinding the substrate in the back-grinding, attaching the protective sheet on an outer side of the substrate of the LED wafer.

5. A method of manufacturing an LED according to any one of claims 1 to 4, further comprising, after the back-grinding, forming a reflective layer.
